# EUROPEAN PATENT APPLICATION

(11) **EP 1 988 555 A1**
(43) Date of publication of application: **05.11.2008**
(21) Application number: 07008974.3
(22) Date of filing: 03.05.2007
(51) Int. Cl.: H01F 1/00, H01F 10/32, H01F 41/30, G11C 11/15

(54) **Nanomagnet array and method of forming the same**

(71) Applicant: Montanuniversität Leoben, 8700 Leoben (AT); RWTH Aachen, 52074 Aachen (DE); University Aachen, 52074 Aachen (DE); Autonomous University Madrid, 28049 Madrid (ES)
(72) Inventor: Teichert, Christian, 8793 Trofaiach (AT); Hofer, Christian, 8605 Kapfenberg (AT); De Miguel, Juan José, Tres Cantos 28760 Madrid (ES); Nino, Miguel Angel, 34131 Triest (IT); Mikuszeit, Nikolai, 22761 Hamburg (DE); Jiménez, Erika, 28002 Madrid (ES); Camarero, Julio, Tres Cantos 28760 Madrid (ES); Miranda, Rodolfo, Tres Cantos 28760 Madrid (ES); Arvanitis, Dimitri, 75649 Uppsala (SE); Gridneva, Lidia, 22655 Lund (SE); Persson, Andreas, 75121 Uppsala (SE); Bobek, Thomas, 52074 Aachen (DE); Kurz, Heinrich, 52074 Aachen (DE)
(74) Representative: Haeusler, Rüdiger Hans-Jörg

(57) **Abstract**

A method for forming a nanomagnet array is provided, wherein the method comprises forming an array of nanoobjects on the substrate, forming a first layer on the nanoobjects in such a way that magnetic nanodots are formed on the nanoobjects, wherein the magnetic nanodots are substantially magnetically decoupled.

## Description

The invention relates to nanomagnet arrays.

The invention further relates to a method of forming nanomagnets.

Moreover, the invention relates to a Magneto-resistive Random Access Memory.

Intense research is being devoted to develop nanofabrication procedures capable of producing discrete magnetic media appropriate for ultra-high density data storage. While lithographic methods concentrate on improving existing patterning technologies so that increasingly smaller features can be transferred to the surface, bottom-up approaches try to mimic nature and rely on natural, spontaneous processes to produce large amounts of identical nanometric objects.

Such a process is known from "Imaging of magnetic nanodots on self-organized semiconductor substrates", Mulders et al., Physical Review B 71, 214422 (2005), in which arrays of magnetic nanodots are prepared by evaporation in ultrahigh vacuum onto self-organized templates consisting of nanometric pyramids of SiGe alloy previously grown on Si(001). Cobalt (Co) is deposited by molecular beam epitaxy at grazing incidence, so that preferential deposition occurs on the island facets facing the Co flux. The films' structural and magnetic morphology can be characterized by means of mirror electron microscopy and x-ray photoemission electron microscopy with magnetic circular dichroism. The morphology of the Co deposit is dictated by the surface template. The Co dots are elongated along the direction perpendicular to deposition due to geometrical factors of the surface at grazing incidence and via steering by the surface steps, and this promotes a uniaxial magnetic anisotropy in this direction. The dots are ferromagnetic and single domain at room temperature. Macroscopic magnetic domains composed of several dots are observed. This indicates that the dipolar interaction between them is stronger than the coercivity; the direct exchange interaction between dots seems negligible.

While these procedures could allow for massively parallel production and delivering high throughput at a low cost. Their main drawback is the difficulty in accurately controlling the uniformity and properties of the nanoobjects.

It is an object of the invention to provide a method of forming nanomagnet arrays, wherein the method provides an accurate controlling of the uniformity and properties of the nanomagnets.

In order to achieve the object defined above nanomagnet arrays, a method of forming nanomagnets and a Magneto-resistive Random Access Memory according to the independent claims are provided.

According to an exemplary embodiment of the invention a method of forming a nanomagnet array is provided, wherein the method comprises forming an array of nanoobjects on the substrate, forming a first layer on the nanoobjects in such a way that magnetic nanodots are formed on the nanoobjects, wherein the magnetic nanodots are substantially magnetically decoupled.

According to an exemplary embodiment of the invention a nanomagnet array comprises a substrate having a plurality of nanoobjects formed on one surface of the substrate and a first layer formed on the nanoobjects, wherein the first layer is formed in such a way that an array of magnetic nanodots are formed on the plurality of nanoobjects in such a way that the magnetic nanodots are substantially magnetically decoupled from each other.

According to an exemplary embodiment of the invention a Magneto-resistive Random Access Memory is provided which comprises a nanomagnet array according to an exemplary embodiment. In particular, the Magneto-resistive Random Access Memory comprises a plurality of wordlines and a plurality of bitlines, wherein the plurality of nanodots is connected to the plurality of wordlines and the plurality of bitlines. More particularly, each of the plurality of nanodots is connected to exactly one of the plurality of wordlines and to exactly one of the plurality of bitlines.

In the context of this application, the term "decoupled" or "substantially decoupled" may particularly denote the fact that the decoupled nanodots may be used in the field of magnetical storage media. That is, the decoupling may be to such an extension that a write/read step relating to one magnetic nanodot does not influence the state of adjacent magnetic nanodots. However, in some cases a residual coupling may still be possible and may also be covered by the term "decoupled".

In the context of this application, the term "first layer" may not indicate that this layer is directly deposited onto the substrate, but it may also be possible to deposit one or several intermediate layers between the substrate and the first layer. Furthermore, the term "first layer" may not indicate that this layer represents a continuous layer, i.e. the first layer may comprise a plurality of partial layers which are arranged on different portions of the substrate, wherein the partial layers are separated by areas on which no first layer is formed. However, also a continuous first layer is possible, which may cover one surface of the substrate.

In the context of this application, the term "nanomagnet array" may particularly denote an array of magnetic objects, e.g. objects which can be brought into different magnetic states, wherein the size of each single nanomagnet is in the nanometer scale, e.g. a size of 500 nm or less, in particular less than 300 nm, e.g. in the range of about 250 nm and 10 nm and more specifically in the range of about 200 nm and 100 nm.

It may be seen as a gist of an exemplary embodiment, to provide a nanomagnet array in which the single nanomagnets are built by a layer formed in such a way that some parts of the first layer act as the nanomagnets while other parts of the same layer act as a shielding for magnetically decoupling the formed nanomagnets from each other. This may lead to an array of nanomagnets which is suitable to be used in a Magneto-resistive Random Access Memory as a memory cell or in the field of super conductivity to control the effect of the so-called magnetic flux tubes of type II super conductors.

Next, further exemplary embodiments of the method of forming a nanomagnet array will be explained. However, these embodiments also apply to the nanomagnet array and to the Magneto-resistive Random Access Memory.

According to another exemplary embodiment of the method the forming of the array of nanoobjects is done by using a self-organizing process. According to another exemplary embodiment of the invention it may also be possible to use prefabricated or preformed self-organized substrates, e.g. self-organized semiconductor substrates, in particular SiGe substrates. Other self-organized substrates may be ion-bombarded hemispherical GaSb dots or similar substrates. In particular, the nanoobjects may be formed by protrusions, e.g. by pyramidal protrusions, wherein the pyramidal protrusions may have a flat top surface, i.e. form mesa structures, so-called "mayan style" pyramids.

According to another exemplary embodiment the method further comprises forming an intermediate layer onto the substrate before depositing the first layer. In particular, the first layer may then afterwards be formed onto the intermediate layer. A gist of this exemplary embodiment may be seen in a way that an interface of a material system is provided, which exhibits a reorientation in case the thickness of the first layer is above a predetermined threshold value.

According to another exemplary embodiment of the method the intermediate layer comprises a non-magnetic metal. In particular, the non-magnetic metal may have a high polarizability and/or spin-orbit coupling. Possible non-magnetic metals may be palladium, platinum, terbium or gold. In particular, the first layer may be formed directly on the intermediate layer, i.e. the two layers may have direct contact with each other.

The use of such a non-magnetic material or metal may enable to enclose the magnetic nanodots at least partially so that the magnetic nanodots are shielded from environmental influences. For example it may be possible to reduce oxidation processes of the magnetic material present in the first layer. In particular, the use of materials having a high polarizability and/or spin-orbit coupling may assist the magnetically decoupling of the magnetic nanodots.

According to another exemplary embodiment of the method the non-magnetic metal of the intermediate layer has a different atomic distance than a material of the first layer. In particular, the material of the first layer may be a magnetic or ferromagnetic material.

In other words the above embodiment may also possess a sufficient amount of local lattice distortion, following the interface lattice mismatch, which may allow for important magneto-elastic contributions to the total magnetic energy, which may lead to similar effects in the magnetization direction as a function of layer thickness as the spin-orbit coupling of the non-magnetic metal at the interface.

By providing two layers, wherein the materials of the layers have different interatomic distances, an efficient way to provide a spin orientation transition may be provided. This may be caused by a gradual elastic relaxation of the material of the first layer, which may be a magnetic or ferromagnetic material. In other words, it may be possible to utilize a spin reorientation, which may be induced by strain, which may be called a magnetoelastic contribution. In particular, in case nickel is used as material of the first layer and copper is used as a material of the intermediate layer, the magnetization may first lay in plane, and as the thickness of the nickel layer increases the magnetization may turn out of plane and may remain out of plane for several nanometer nickel thickness, due to the fact that the nickel may have a tendency to grow slightly tetragonal favouring the out of plane.

According to another exemplary embodiment of the method the first layer comprises a ferromagnetic material. In particular, the first layer may comprise cobalt, iron, nickel, or an alloy thereof, e.g. a cobalt/iron alloy. These metals may be suitable materials to form magnetic nanodots. However, it may also be possible to choose another magnetic material which is not ferromagnetic.

According to another exemplary embodiment of the method the forming of the first layer is done by using a grazing incidence deposition process. In particular, the grazing incidence deposition may be performed under an incidence angle in such a way that the first layer comprises different regions having different thicknesses. That is, a first type of region may have a first thickness, while a second type of region may have a second thickness.

According to another exemplary embodiment of the method one of the different thicknesses is above a predetermined thickness threshold. In particular, the threshold thickness may be determined in such a way that the regions having at least the predetermined thickness exhibiting another magnetization direction than the regions having a thickness which is lesser than the predetermined thickness. Thus, the threshold thickness may be called a transition thickness, since the magnetic orientation of the layer undergoes an transition from out-of-plane to in-plane when the value of the thickness is changed from below the threshold thickness to above the threshold thickness. For example, the first layer may have an in-plane magnetization in the regions having a greater thickness than the predetermined thickness and may have an out-of plane magnetization in regions having a lesser thickness than the predetermined thickness. Thus, it may be possible to magnetically decouple the two regions from each other due to the different magnetization directions of the two regions. In particular, the thicker region may be the decoupling region, in case the magnetic nanodots are formed by thinner regions, or the thinner regions may be the decoupling region, in case the magnetic nanodots are formed by the thicker regions.

In particular, the first layer may comprise three different types of regions. A first one which is formed on the top of the nanoobjects, a second one formed by the side of the nanoobjects which faces the incidence direction and a third one turning away from the incidence direction. The thickness of the layer formed in the first type of regions may be determined or chosen in such a way that this region may form magnetic nanodots suitable for using in a magnetic storage medium. The thickness of the layer formed in the second type of regions is greater than the thickness in the first type of regions, in particular this thickness may be determined such that a sufficient decoupling of areas of the first type is ensured. The thickness of the layer formed in the third type of regions is lower than the thickness in the first type of regions due to a shadowing effect of the nanoobjects, i.e. a part of the material deposited to form the first layer is prevented from depositing in this region due to the shadowing effect.

The forming of different regions of the first layer may provide an efficient way to ensure that some regions, e.g. the magnetic nanodots, are magnetically decoupable from each other by the regions having another thickness of the first layer. In particular, the magnetic nanodots may be formed by regions having a smaller thickness than the regions surrounding the magnetic nanodots. Therefore, the magnetization of the magnetic nanodots may point in the direction of the surface plane, i.e. the so-called "in-plane" direction while the magnetization of the thinner regions between the magnetic nanodots may point normal or perpendicular to the substrate or multilayer stack, i.e. the so-called "out-of-plane-direction". However, as already stated it is also possible to use regions having a lesser thickness to magnetically decouple regions which have a greater thickness and which form the magnetic nanodots. This difference in the direction of the magnetization induced by the difference in the thickness may lead to an efficient shielding of the magnetic nanodots.

According to another exemplary embodiment the method further comprises the forming of an additional layer, wherein the first layer comprises a ferromagnetic material and the additional layer comprises an antiferromagnetic material. In particular, the first layer and the additional layer may be in direct contact, e.g. the first layer may be formed directly on the additional layer.

Such an arrangement of the two layers may lead to the fact that the exchange interaction at the interface between the antiferromagnetic and the ferromagnetic materials blocks the magnetization of the latter, which may increase its coercivity and making it more stable against the influence of the neighboring particles. Suitable antiferromagnetic materials may in particular be cobal oxide, chromium, FeMn alloy or nickel oxide, with appropriate thicknesses so that their Néel temperature, or temperature for the onset of antiferromagnetic ordering, will be above that of operation of the device, e.g. the nanomagnet array or a device which comprises the nanomagnet array. By using a material for the first layer having coercivity higher than a given threshold another efficient way to ensure a magnetic decoupling of the magnetic nanodots with respect to each other may be possible. According to this embodiment it may not be necessary to provide regions of different thickness of the first layer. Preferably, the first layer may have a constant thickness which is above a predetermined threshold. A possible value for the predetermined threshold may be determined in such a way that the Curie temperature of the ferromagnetic nanadots is well above room temperature. A possible thickness threshold may thus be about 3 to 4 ML or about 1 nm for a two-dimensional film, for example.

Next, further exemplary embodiments of the nanomagnet array will be explained. However, these embodiments also apply to the method of forming a nanomagnet array and for the Magneto-resistive Random Access Memory.

According to another exemplary embodiment of the nanomagnet array the first layer comprises a ferromagnetic material. In particular, the ferromagnetic material may be iron (Fe), cobalt (Co), nickel (Ni) or an alloy thereof.

According to another exemplary embodiment the nanomagnet array further comprises an intermediate layer, which is arranged between the substrate and the first layer. In particular, the intermediate layer may comprise a non-magnetic material. For example, the non-magnetic material may be palladium, platinum, terbium or gold.

According to another exemplary embodiment of the nanomagnet array the first layer has a first thickness on a top-surface of the plurality of nanoobjects and a second thickness on sidefaces of the plurality of nanoobjects. In particular, the first thickness and the second thickness may be different. For example, the difference of the first thickness and the second thickness may be chosen in such a way that in regions having the first thickness the magnetization points normal to the layer (out-of plane magnetization) and in regions having the second thickness the magnetization points in the surface plane (in-plane magnetization). In particular, the first thickness may be smaller than the second thickness. More specifically the second thickness may have such a value that shape anisotropy dominates over interface anisotropy so that magnetization may be dominated by the shape anisotropy, which may lead to the in-plane magnetization. For example, the second thickness may be greater than 1 nm, more specifically the second thickness may be greater than about 1.2 nm or even greater than 1.3 nm. For example, the second thickness may be between 1.0 nm and 3 nm, more specifically between 1.2 nm and 2.0 nm

According to another exemplary embodiment the nanomagnet array further comprises a top layer, which is formed on the first layer. In particular, the top layer is formed of a non-magnetic material. In particular, the same non-magnetic material as the intermediate layer. More specifically, a multilayer structure or multilayer stack may be formed on the substrate which multilayer structure may comprise a number of layers comprising an alternating material. For example a multilayer stack may comprise three or five layers, wherein the first layer comprising a non-magnetic material, the second layer comprises a ferromagnetic material, the third one comprises a non-magnetic material, the fourth one comprises a ferromagnetic material, while the fifth layer comprises a non-magnetic material again. Possible combinations of layers may be cobalt/gold (Co/Au), cobalt/nickel (Co/Ni), an alloy of iron and cobalt/platinum (FeCo/Pt), an alloy of cobalt and platinum/gold (CoPt/Au), iron/terbium (Fe/Tb), nickel/palladium (Ni/Pd), nickel/platinum (Ni/Pt), iron/platinum (Fe/Pt), cobalt/platinum (Co/Pt). All these combinations of layers may exhibit perpendicular magnetic anisotropy due to the interfacial anisotropy accumulated with the repetition of alternating layers. Summarizing, the simplest multilayer may consist of alternating layers of one element of each kind, i.e. a ferromagnetic material and a non-magnetic metal with high polarizability and/or spin-orbit coupling, or combinations thereof. More complex structures may also be used in order to tailor some magnetic characteristics, e.g. coercivity or energy product.). Some of this more complex structures may be neodymium-iron-boron/iron-cobalt (Nd-Fe-B/FeCo) bilayer films formed as a nanocomposite having perpendicular magnetic anisotropy, an alloy of sputtered nickel iron molybdenum/ruthenium/cobalt platinum (NiFeMo/Ru/CoPt) trilayer thin films, wherein the magnetic and structural properties of these films may be exploited, e.g. for perpendicular recording media. Another suitable structure may be a multilayer comprising cobaltoxide (CoO) and permalloy, i.e. an alloy comprising nickel and iron. In this structure CoO is not ferromagnetic but antiferromagnetic.

Summarizing one exemplary aspect of the present invention may be seen in the fact that a strategy has been developed to reduce the coupling among self-organized magnetic nanoparticles grown by grazing-angle evaporation onto SiGe templates. The Co thickness in (Pt/Co/Pt) trilayers may be carefully chosen so that the spin reorientation transition from perpendicular to in-plane magnetization is only crossed at the thicker deposits produced on the surface facets directly exposed to the Co beam, but not on the remaining area. The regions between the nanomagnets, having a different magnetization direction than these latter, thus act as effective domain walls screening their interaction and resulting in the formation of large area arrays of magnetized, spontaneously-ordered and nearly independent nanoparticles, which may be demonstrated by Photo Emission Electron Microscopy with X-Ray Magnetic Circular Dichroism (XMCD-PEEM) experiments and confirmed by micromagnetic calculations for example, which may be shown in the following. Thus, a technique may be developed to reduce the effect of the unavoidable magnetostatic interaction between adjacent particles and make them magnetically independent of each other. This technique describes a procedure based on immersing the nanomagnets in another region with different magnetization orientation, thus possibly creating effective domain walls between the particles that may break the continuity in the alignment of their magnetization and may favour their random orientation. Thus, it may be possible to use the array of nanomagnets for recording media since it may be possible to control and modify the magnetic state of every particle or nanodot independently of the rest. In particular, it may be possible to manufacture a Magneto-resistive Random Access Memory (MRAM), wherein for writing a relatively high current is applied to the buslines, while for reading a low reading voltage is used. Thus, the reading current occurring while reading depends on the magnetic field of the nanomagnets. A key feature may be to exploit the transition from out-of-plane to in-plane magnetization with increasing thickness of the ferromagnetic layer as the shape anisotropy overcomes the interfacial contribution. Preferably, a Magneto-resistive Random Access Memory according to an exemplary embodiment of the invention may be read-out by magneto-optical reading, which may be advantageous when so-called out-of plane magnetized materials are used since the Kerr rotation is about 10 times larger than with in-plane media, thus possibly leading to a clear signal in the read-out.

The aspects defined above and further aspects of the invention are apparent from the examples of embodiment to be described hereinafter and are explained with reference to these examples of embodiment.

The invention will be described in more detail hereinafter with reference to examples of embodiment but to which the invention is not limited.

Figure 1 schematically illustrates a cross-sectional view of a nanomagnet array according to an exemplary embodiment.

Figure 2 shows an image of a self-organized SiGe substrate.

Figure 3 shows an X-ray absorption image.

Figure 4 shows an alignment of magnetized particles.

The illustration in the drawing is schematic. In different drawings, similar or identical elements are provided with similar or identical reference signs.

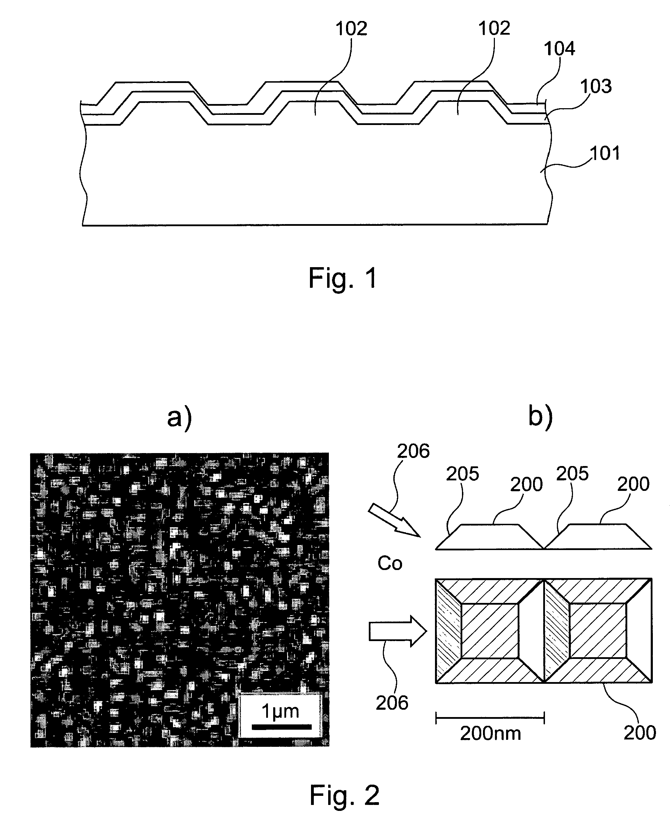

In the following, referring to **Fig. 1 to 4****,** a nanomagnet array and a method of producing the same will be explained.

**Fig. 1** shows a schematic illustration of a cross-sectional view of a nanomagnet array according to an exemplary embodiment. The nanomagnet array 100 comprises a SiGe substrate 101 having a plurality of protrusions 102 formed by self-organizing processes. Onto the substrate 101 an intermediate layer 103 is formed , which comprises a non-magnetic metal. The deposition of the intermediate layer 103 is preferably done by impinging a platinum beam onto the substrate 101 under an angle which is substantially perpendicular to the top surface of the substrate so that the intermediate layer 103 has a substantially constant thickness. Next a ferromagnetic first layer 104 is formed on the intermediate layer 103, which first layer 104 comprises cobalt. Preferably, the deposition of the first layer is done under grazing incidence so that at least on one sideface of the protrusions 102 the thickness is greater than on the topside and the opposite sideface. To indicate this, the intermediate layer 103 is depicted to be thicker on the left side of the protrusions than on the right side in Fig. 1. It is also possible to increase the thickness of the first layer 104 on two sides of the protrusions by choosing an incidence direction which points along the diagonal of the protrusions.

In particular, a procedure based on immersing nanomagnets in another material with different magnetization orientation will be described, thus creating effective domain walls between the particles that break the continuity in the alignment of their magnetization and favour their random orientation. Cobalt/platinum (Co/Pt) multilayers may be suited for this purpose, since they present a rather high magnetic anisotropy and their properties, such as the coercivity or the reorientation transition from out-of-plane to in-plane magnetization can be tuned by precisely controlling the thicknesses of the individual layers and the number of periods. In Co films thinner than ca. 1.2 nm interface anisotropy dominates and the magnetization points normal to the multilayer stack. For higher Co thicknesses, shape anisotropy wins and the magnetization turns into the surface plane. Based on this behaviour, the topographic features of the self-organized substrates may be exploited to grow periodically distributed (Co/Pt) nanoparticles with uncorrelated magnetization.

For example the SiGe templates chosen according to the described embodiment may comprise of an arrangement of truncated or so-called "mayan-style" pyramids 200 with approximately square base, as revealed by the AFM image shown in **Fig. 2a****.** The inclination of the pyramids' side facets with respect to the top terraces is approximately 25°, corresponding to the {113} orientation. Co and Pt were deposited at angles of 16° and 45° from the surface plane, respectively. The grazing deposition geometry is illustrated in **Fig. 2b** in side and top views. The facets 205 confronting the incoming Co beam receive the highest flux, while those in the back of the pyramids 202 remain shadowed. The direction of the Co beam is schematically indicated by the arrows 206. The thicknesses deposited on the different facets are schematically represented by the colour code, darker shading meaning thicker Co deposits. Preferably, the process starts by evaporating Pt at a less grazing incidence to ensure that substantially no shadowing effects will take place and the semiconductor substrate will be covered substantially homogeneously. Then, the amount of deposited Co is carefully chosen so that the magnetization reorientation transition is just surpassed on the facets oriented directly towards the Co beam -dark colour shade in Fig. 2b, but not on the other facets receiving a lower flux of material -light shaded areas in the same drawing-. In this way, it may be possible to obtain a regular arrangement of in-plane magnetized nanoparticles, distributed following the surface template and interspersed in a sea of out-of-plane magnetized material.

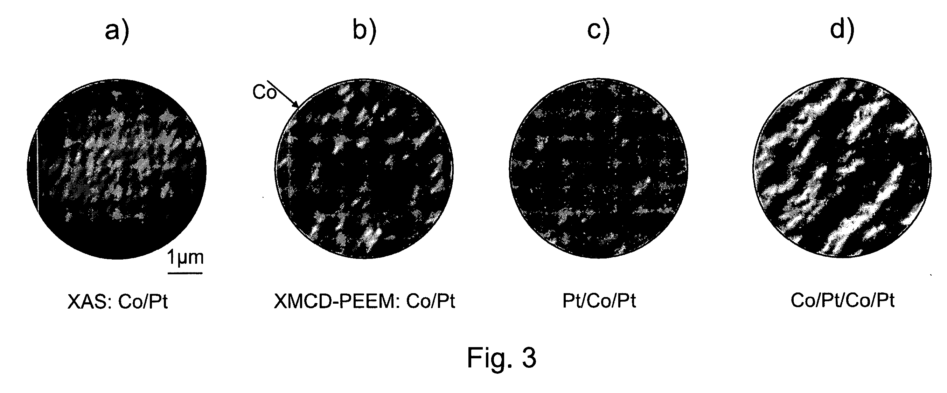

The success of this approach is demonstrated by the PEEM images displayed in **Fig. 3**, which in panel (a) shows an X-Ray absorption (XAS) image tuned at the Co L₃ edge after deposition of 4 monolayers (ML) of Pt and 4.5 ML of Co on the SiGe substrate depicted in Fig. 2, showing how the concentration of Co on the surface follows the surface template. **Fig. 3b** shows an XMCD-PEEM image with magnetic contrast in the same region: In-plane magnetized nanoparticles can be observed at room temperature. Dark and bright represents opposite orientation of the particles magnetization with respect to the light polarization direction. **Fig. 3c** and **Fig. 3d** are additional XMCD-PEEM images after the successive deposition of another 4 ML Pt and a final 2 ML Co. The field-of-view is 5 µm in all cases.

These experiments were conducted at the Photoelectron Emission Microscopy beamline of a synchrotron, wherein all the depositions and measurements were performed at room temperature. The X-ray photon energy was tuned to the Co L₃ absorption edge, i.e. 778 eV. In the total X-ray Absorption (XAS) image depicted in **Fig. 3a****,** corresponding to a 4.5 monolayers (ML) Co and 4 ML Pt structure, the intensity is proportional to the Co concentration at each point, thus revealing that the distribution of Co on the surface follows indeed the template created by the SiGe substrate. X-ray Magnetic Circular Dichroism (XMCD) pictures with magnetic contrast were obtained by acquiring two successive absorption images at the same spot on the surface using light with left- and right-handed circular polarization, and subtracting them. The angle of incidence of the X-ray beam onto the sample is fixed at 16° with respect to the surface; since the dichroic asymmetry is proportional to the dot product k·M, out-of plane magnetized regions produce negligible contrast in the XMCD-PEEM images. The first hints of in-plane remanence start to appear at 3.5 ML Co thickness; for 4.5 ML, a well-developed pattern of magnetic dots can be observed in Fig. 3b. Here, bright and dark spots reveal particles with opposite magnetization directions with respect to the beam polarization. Their average size, 240 nm x 80 nm, and separation, 250 nm, indicate a 1:1 correspondence to the surface features. Grey areas show no dichroic contrast, and could be non-magnetic regions, but more probably they are actually out-of-plane magnetized, as will be shown below.

Simple visual inspection of the XMCD-PEEM image in Fig. 3b demonstrates that the magnetic order exhibited by the (Co/Pt) nanoparticles is quite different from that observed in samples of pure Co. Instead of relatively large domains grouping together many particles with the same orientation of the magnetization, now only small groups and even a significant amount of single dots aligned opposite to their neighbours is observed. The degree of correlation can be roughly quantified by counting the number of nanomagnets showing parallel/antiparallel magnetization. The results for all samples are given in Table I.

When analyzing these images it should be kept in mind that not all of the Co nanoparticles within the microscope's field of view display magnetic contrast, as the comparison between the two images in Figs. 3a and 3b unequivocally demonstrates. Due to irregularities in the self-organized surface template, some dots may not have reached the critical Co thickness and their magnetization may remain out-of-plane, showing no dichroic contrast. For these reason, some of the in-plane magnetized nanoparticles are only surrounded by grey area, with no dichroic nearest neighbours. The number of those "isolated" dots is listed in a separate column in Table I. After these measurements, an additional Pt layer, also 4 ML thick was deposited on top of the Co. Some significant changes can be observed in the XMCD-PEEM image of this sample shown in Fig. 3c. In the first place, the size of the in-plane magnetized particles is reduced, being now typically 200 nm x 110 nm accounting for an aspect ratio of only 1.8 compared to 3 for the spots shown in Fig. 3b. The capping with Pt doubles the perpendicular anisotropy of the nanoparticles, switching again out-of-plane the magnetization at their edges, where the Co thickness is smaller. This observation also supports an interpretation that the absence of dichroic contrast in many regions of the sample with uncapped Co was indicative of the perpendicular alignment of the film's magnetization rather than due to its not being magnetic. Secondly, the density of in-plane magnetized particles is reduced, for the same reason, some of them have turned out-of-plane completely and are no longer visible with the XMCD-PEEM set-up in use. Finally, the percentage of isolated dots is increased. All of these observations can be explained by considering that the area with perpendicular magnetization has increased and became more efficient in counteracting the tendency of the magnetostatic interaction to force the alignment of the dots.

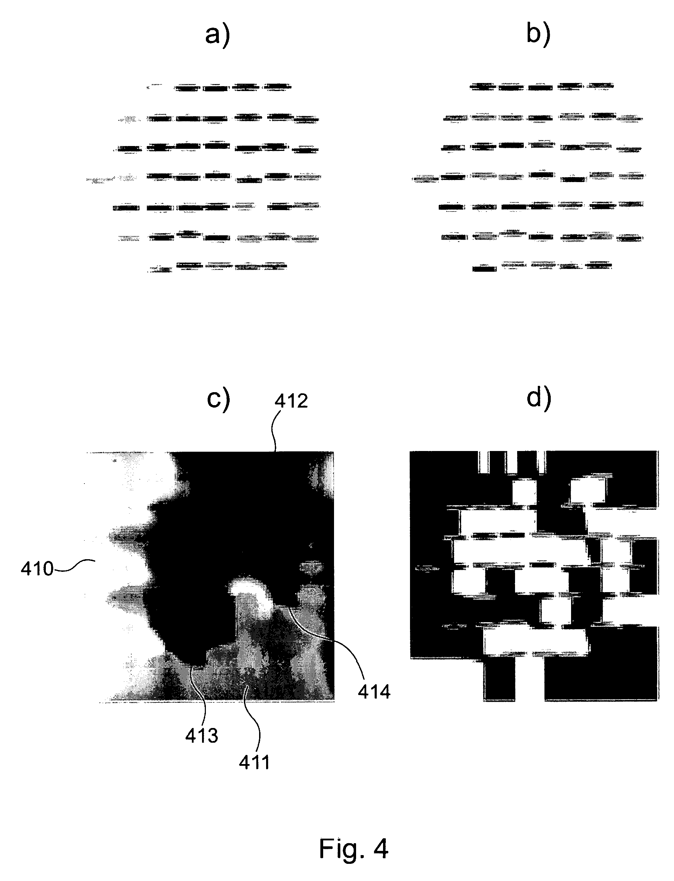

To cross-check the analysis of the experimental data, micromagnetic simulations have been performed using the OOMMF free software package. The cells were 3 atomic layers thick and 5 x 5 nm² in the plane, which is smaller than the domain wall width. The base layer is continuous, with double-layer, elliptic particles placed on the second and third levels. These nanomagnets have long and short axes of 190 nm and 40 nm, respectively. Their center-to-center distance is 200 nm -see **Fig. 4a** and **Fig. 4b****-.** Each layer contained effective media defined by their magnetic characteristics: a saturation magnetization MS = 1.416 × 10⁶ A/m and an exchange stiffness A = 3 x 10¹¹ J/m, which are typical values for Co. Additionally, a perpendicular anisotropy KS = 0.5 mJ/m² was introduced in the continuous film to simulate a single (Co/Pt) interface; twice this value, 2KS, mimicked the (Pt/Co/Pt) trilayer. In the first case, the perpendicular anisotropy was unable to compensate the shape contribution Kₛₕ ≈ µ₀(Mₛ)²/2 and the film was in-plane magnetized. On the contrary, for the double (Co/Pt) interface structure, the perpendicular term won and the base film was magnetized out-of plane. The particles and the region beneath them within the base layer always had in-plane magnetization.

As magnetic states which represent local minima in energy are most interesting, the standard energy minimization algorithm was used. The results thus do not necessarily represent the global ground state. Without any interparticle coupling the nearest-neighbour correlation in the demagnetized state should be zero, both within a row and with the neighbouring rows. On the other hand, the elliptical particles have high shape anisotropy and consequently with increasing dipolar coupling the correlation within a row should tend to 1 while with the neighbouring rows should approach -1. The equilibrium configuration hence would consist of antiparallel magnetized rows. In the shown case one has also to count on the strong effect of the base layer, as will be shown below.

For both kinds of films (in-plane and out-of-plane) domains are observed. Their orientation is shown in Figs. 4c and 4d with a colour code in the surface plane, white and black for perpendicular up and down. Thus, the areas 410, 411, 412, 413, and 414 have different magnetization orientations. Fig. 4a and Fig. 4b show the alignment of a set of in-plane magnetized particles lying on a continuous film with in-plane and out-of-plane magnetization, respectively, as derived from micromagnetic simulations. In **Fig. 4c** and **Fig. 4d** the domain structure of the corresponding base films is shown. White and black in Fig. 4d denote up and down.

In the out-of plane film so-called Bloch walls with a width b~11 nm are found. The in-plane magnetized particles at the overlayer are starting points for domain walls. When these latter merge with a particle at its long side, they have to transform to a so-called Néel-type. Hence, the magnetic information between neighbouring rows is lost, and no interaction between them is carried through. Within a row the walls start directly of a so-called Bloch type, carrying the information about the particles magnetization. The statistics of nearest-neighbour alignment derived from these calculations is also summarized in Table I. It is evident that the tendency to form parallel pairs has been largely suppressed. The particle-to-particle correlation within rows is close to zero (-0.025), which indicates nearly random orientation. Between rows, a strongly negative value (- 0.35) is found, which probably results from statistical errors, as the corresponding interaction is very weak. Finally, the effective particle size is reduced in agreement with the experimental observations, as parts of the particles' magnetization are tilted out-of-plane by the exchange interaction with the film.

For the in-plane magnetized base layer, on the contrary, large domains and soft vortex-like transitions can be seen. The nanomagnets are also grouped in domains, reflecting an intense interparticle coupling not only within a row but also between neighbouring rows. The particles' alignment is clearly determined by the domain structure of the continuous base film, as demonstrated by Figs. 4a and 4c. Both the interparticle correlations (0.7 within a row and 0.5 between rows) and the statistics of pair alignment listed in Table I confirm the strong tendency of these particles to orient themselves parallel to their neighbours.

**Table 1**

| Samples | Number of nanomagnet | Parallel pairs | Antiparallel pairs | Isolated |
|---|---|---|---|---|
| Co/Pt/SiGe | 76 | 35% | 45% | 20% |
| Pt/Co/Pt/SiGe | 49 | 38% | 37% | 25% |
| {Co/Pt}₂/SiGe | 135 | 59% | 40% | 1% |
| Simulation (in-plane film) | | 80% | 20% | |
| Simulation (out-of-plane film) | | 41% | 59% | |

As an additional experimental test, a second Co layer just 2 ML thick was evaporated in-situ on top of the last Pt in the same sample described above. Thus, the XMCD-PEEM images of Figs. 3c and Fig. 3d were acquired at exactly the same surface position. The effect of this Co film was to turn the magnetization in-plane all over the surface, substantially raising the percentage of correlated nanomagnets as reflected in Table I. The relatively high percentage of antiparallel pairs comes possibly exclusively from the domain borders. Nearly all of the nanoparticles show dichroic contrast, the number of isolated dots being correspondingly reduced. The particles are coupled forming large domains elongated along the direction perpendicular to the incoming Co beam, due to the anisotropy induced by the grazing deposition angle. Clearly, the decoupling effect of the out-of-plane patches has disappeared.

In conclusion, a method for producing a nanomagnet array is described in which the magnetostatic coupling among neighbouring nanoparticles may be reduced by immersing them in another material with different magnetization orientation, thus possibly creating reorientation transition regions. This technique may have widespread use for the production of magnetic nanostructures. The grazing deposition method and the creation of in-plane magnetized particles separated by out-of plane borders may also be applied to lithographically defined substrates, or those produced by using other self-assembly and self-organization techniques.

It should be noted that the term "comprising" does not exclude other elements or features and the "a" or "an" does not exclude a plurality. Also elements described in association with different embodiments or aspects may be combined. It should also be noted that reference signs in the claims shall not be construed as limiting the scope of the claims.

## Claims

1. A method for forming a nanomagnet array, the method comprising:
forming an array of nanoobjects on a substrate; and
forming a first layer on the nanoobjects in such a way that magnetic nanodots are formed on the nanoobjects, wherein the magnetic nanodots are magnetically decoupled.

2. The method according to claim 1,
wherein the forming of the array of nanoobjects is done by using a self-organizing process.

3. The method according to claim 1 or 2, further comprising:
forming an intermediate layer onto the substrate before depositing the first layer.

4. The method according to claim 3,
wherein the intermediate layer comprises a non-magnetic metal.

5. The method according to claim 4,
wherein the non-magnetic metal has a high polarizability and/or spin-orbit coupling.

6. The method according to claim 4,
wherein the non-magnetic metal of the intermediate layer has a different atomic distance than a material of the first layer.

7. The method according to any one of the claims 1 to 6,
wherein the first layer comprises a ferromagnetic material.

8. The method according to any one of the claims 1 to 7,
wherein the forming of the first layer is done by using a grazing incidence deposition process.

9. The method according to claim 8,
wherein the grazing incidence deposition is performed under an incidence angle in such a way that the first layer comprises different regions having different thicknesses.

10. The method according to claim 9,
wherein one of the different thicknesses is above a predetermined thickness threshold.

11. The method according to any one of the claims 1 to 7, further comprising
forming an additional layer,
wherein the first layer comprises a ferromagnetic material, and
wherein the additional layer comprises an antiferromagnetic material.

12. A nanomagnet array comprising:
a substrate having a plurality of nanoobjects formed on one surface of the substrate; and
a first layer formed on the nanoobjects;
wherein the first layer is formed in such a way that an array of magnetic nanodots are formed on the plurality of nanoobjects in such a way that the magnetic nanodots are magnetically decoupled from each other.

13. The nanomagnet array according to claim 12,
wherein the first layer comprises a ferromagnetic material.

14. The nanomagnet array according to the claim 12 or 13, further comprising:
an intermediate layer, which is arranged between the substrate and the first layer.

15. The nanomagnet array according to claim 14,
wherein the intermediate layer comprises a non-magnetic material.

16. The nanomagnet array according to any one of claims 12 to 15,
wherein the first layer has a first thickness on a top-surface of the plurality of nanoobjects and a second thickness on side-faces of the plurality of nanoobjects.

17. The nanomagnet array according to any one of the claims 12 to 16, further comprising:
a top layer, which is formed on the first layer.

18. The nanomagnet array according to claim 17,
wherein the top layer is formed of a non-magnetic material.

19. A Magneto-resistive Random Access Memory comprising:
a nanomagnet array according to any one of the claims 12 to 18.

20. The Magneto-resistive Random Access Memory according to claim 19, further comprising:
a plurality of wordlines; and
a plurality of bitlines,
wherein the plurality of nanodots is connected to the plurality of wordlines and the bitlines.
